Europäisches Patentamt

European Patent Office

Office européen des brevets

(19)

(11) Numéro de publication: **0 238 379**
**B1**

(12) **FASCICULE DE BREVET EUROPEEN**

(45) Date de publication du fascicule du brevet: **16.01.91**

(51) Int. Cl.⁵: **G 11 C 11/407, G 11 C 7/00**

(21) Numéro de dépôt: **87400326.2**

(22) Date de dépôt: **13.02.87**

(54) **Mémoire dynamique à écriture monocycle d'un champ d'états logiques.**

(30) Priorité: **18.02.86 FR 8602183**

(43) Date de publication de la demande:
**23.09.87 Bulletin 87/39**

(45) Mention de la délivrance du brevet:
**16.01.91 Bulletin 91/03**

(84) Etats contractants désignés:
**DE FR GB IT NL**

(56) Documents cités:
**EP-A-0 144 710**
**US-A-4 491 936**

**IBM TECHNICAL DISCLOSURE BULLETIN, vol. 27, no. 6, novembre 1984, pages 3469-3470, IBM, New York, US; P. NACK et al.: "Substrate voltage, bump test for dynamic RAM memory devices"**

**RESEARCH DISCLOSURE, no. 254, juin 1985, page 290, Emsworth, Hampshire, GB; "1D Cell memory system with pulsed storage plate for multiplexed bit lines"**

(73) Titulaire: **SGS-THOMSON MICROELECTRONICS S.A.**
**7, Avenue Galliéni**
**F-94250 Gentilly (FR)**

(72) Inventeur: **Chevallier, Christophe**
**THOMSON-CSF SCPI 19, avenue de Messine**
**F-75008 Paris (FR)**

(74) Mandataire: **Ballot, Paul Denis Jacques et al**
**Cabinet Ballot-Schmit 7, rue le Sueur**
**F-75116 Paris (FR)**

Courier Press, Leamington Spa, England.

**Description**

L'invention concerne une mémoire dynamique à écriture monocycle d'un champ d'états logiques. Elle trouve application dans la constitution de plans mémoires de grosses capacités, isolés ou intégrés à une unité centrale.

Dans l'art antérieur une mémoire dynamique pour être chargée doit d'abord être adressée puis un état logique est transmis à l'adresse désirée. Ainsi pour un cycle d'adresse une seule adresse est accessible à la fois. En multipliant les rangs adressables, on peut augmenter pour une capacité de mémoire dynamique la quantité d'états logiques entrée sur un cycle, mais l'écriture d'un champ complet est long. En particulier cette disposition est désavantageuse pour d'initialisation des mémoires d'images utilisées par les processeurs graphiques.

Il est par ailleurs connu d'utiliser une plate line commandée par le décodeur d'adresse de la mémoire pour améliorer la marge du signal stocké par la cellule: en déplaçant le potentiel de la plate line avant ou après la sélection d'une ligne de mot, puis en replaçant le potentiel avant la désélection de la ligne de mot, on peut augmenter un niveau haut stocké par la cellule, ou conserver un niveau bas. Un tel procédé est décrit dans le brevet US 4 491 936.

Mais l'utilisation d'un tel procédé ne permet pas de mettre à un même niveau physique toutes les cellules d'une mémoire dynamique.

C'est un but de la présente invention de proposer une disposition particulière qui permette d'écrire un champ de bits d'une valeur donnée en un seul cycle d'écriture.

D'autre part l'invention ne s'identifie pas à la démarche qui consiste à multiplier les moyens d'adressage de la mémoire dynamique pour augmenter la vitesse d'inscription globale. Au contraire, relativement à ce type de solution l'invention propose une disposition plus simple et moins coûteuse qui ne consomme pas beaucoup de la surface utile du silicium sur le circuit intégré où est implantée la mémoire dynamique selon l'invention.

En effet, l'invention concerne une mémoire dynamique telle que la capacité de stockage de chaque cellule de la mémoire est connectée par une première borne à un générateur de potentiel. Ce générateur de potentiel est destiné, sur une commande, à modifier le potentiel de l'autre borne de la capacité de stockage d'une quantité telle que, selon l'état de l'information stockée dans chaque cellule, la capacité se décharge, de façon à mettre toutes les cellules à un même niveau physique.

L'invention s'utilise avantageusement dans l'initialisation de plans mémoire de grande capacité comme les mémoires d'images numériques.

D'autres caractéristiques et avantages de la présente invention seront mieux compris à l'aide de la description et des dessins qui sont:

la figure 1: un schéma d'une paire de cellules d'une mémoire dynamique selon l'invention;

les figures 2a, 2b, 2c: trois figures décrivant l'évolution des potentiels entre un état initial et un état final;

la figure 3: un schéma d'un circuit de sortie d'une mémoire dynamique destinée à être initialisée en bloc.

Selon l'invention, il est désiré de mettre à un même niveau physique toute les cellules d'une mémoire dynamique.

La capacité d'une cellule est formée de deux conducteurs A et B et d'un diélectrique, un des conducteurs ("A" par exemple) conservant la charge. Cette charge est amenée sur le conducteur A par un transistor. Au repos, le transistor est bloqué, et la charge est stockée.

L'autre conducteur B est en fonctionnement normal à potentiel fixe. Selon l'invention on modifie ce potentiel, de manière à déplacer, par couplage capacitif, le potentiel sur le conducteur A. Selon son niveau, le potentiel sur le conducteur A est déplacé de manière à rendre le transistor sus-mentionné passant. Le conducteur B est alors replacé à son niveau en fonctionnement normal. Le potentiel du conducteur A, par couplage, se déplacera d'autant que le potentiel du conducteur B.

Premier cas: le transistor devient passant pendant le premier déplacement du conducteur B; le niveau stocké prend alors une nouvelle valeur, liée à l'amplitude du déplacement du conducteur B, à la tension de grille et à la tension de seuil du transistor.

Deuxième cas: le transistor reste bloqué, le niveau stocké suit les variations de B et revient à son niveau initial, la charge stockée est conservée.

Le déplacement du conducteur B doit être tel que la variation finale de potentiel sur le conducteur A dans le premier cas ramène le potentiel du conducteur A à un niveau proche du potentiel du deuxième cas.

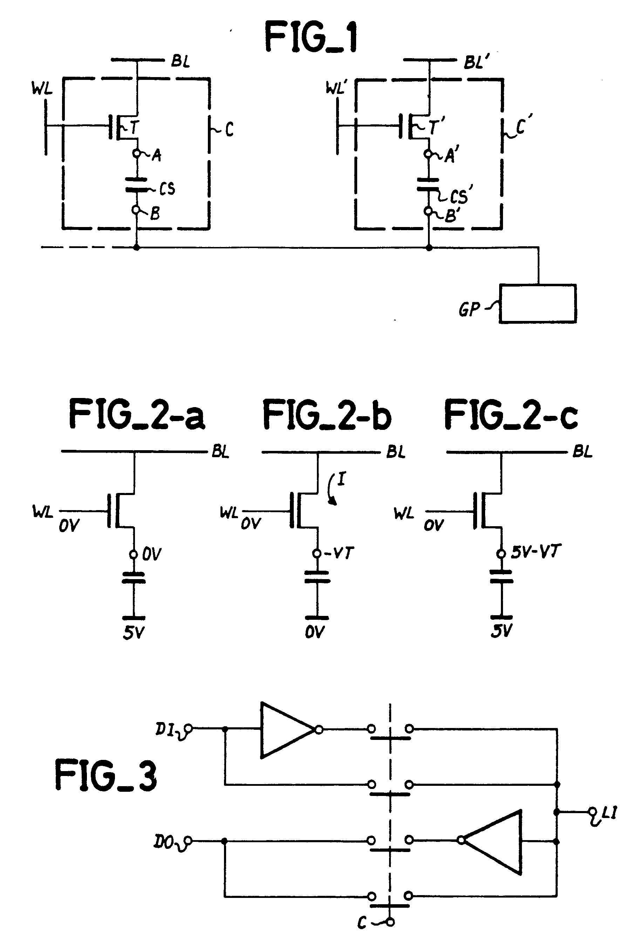

Dans l'exemple des figures 2a à 2c, on décrit un cycle de fonctionnement subi par une cellule dont les caractéristiques sont les suivantes. Transistor NMOS, niveau de précharge de ligne de donnée (Bit Line) supérieure ou égale à 0V. Ligne de mot (Word Line) à 0V, plaque de la capacité (conducteur B) à 5V.

Cycle sur le conducteur B: 5V à 0V à 5V (de l'état initial à l'état final).

Cycle du niveau stocké:

premier cas, le niveau stocké à 5V descend à 0V et remonte à 5V. Pas de modification de niveau.

deuxième cas, le niveau stocké à 0V descend vers −5V, rendant le transistor passant, le potentiel du conducteur A passe à 0V−Vt.

Quand le potentiel sur B repasse à 5V, le potentiel sur A passe à 5V−Vt (Vt=tension de seuil du transistor). Il y a modification du niveau stocké dans la cellule mémoire.

Ce déplacement du conducteur B est appliqué sur toute ou partie de la mémoire.

Toutes les cellules sur lesquelles ce cycle est appliqué sont donc à un niveau de 5V ou 5V−Vt. Elles sont donc à un niveau physique semblable et seront lues, suivant leurs emplacements, comme un même niveau logique. La détermination de ce niveau logique, en fonction de l'emplacement est étudiée en deuxième partie.

Dans une utilisation avantageuse de l'invention, il est désiré de mettre à un niveau logique toutes les cellules d'une mémoire dynamique.

Dans une mémoire dynamique, la donnée ou la donnée complémentée sont stockées, suivant l'adresse de la cellule mémoire considérée.

Il suffit, en fonction de son adresse, d'inverser la donnée complémentée, ou d'attaquer un des étages amplificateur en inversant les entrées de cet étage, pour rétablir en sortie la donnée. Ce principe est couramment utilisé dans les circuits à mémoires. Nous considérons donc dans ce qui suit que le niveau stocké correspond au niveau à sortir. Ainsi, sur une mémoire standard, en stockant un niveau logique constant dans toute la mémoire, ce niveau sera conservé en sortie.

Le dispositif décrit à la figure 3 permet de lire des 1 ou des 0 à partir d'un niveau physique constant (5V pour l'exemple de la figure 2). Ce dispositif permet de créer deux modes particuliers de la mémoire: écriture d'un champ de 0, écriture d'un champ de 1. Ces modes doivent être sélectionnés par une commande indiquant le niveau logique à écrire. La commande peut être élaborée par un circuit interne de la mémoire à partir de signaux de contrôle comme le signal de sélection ou le signal d'initialisation.

Le dispositif consiste à inverser ou non les buffers d'entrées et de sorties en fonction du niveau logique désiré.

Ainsi, lors de l'exécution de la commande de, par exemple, mise à zéro de l'ensemble de la mémoire, la mémoire est mise à niveau physique 5V (cas de notre exemple) et les données sont inversées en sortie. Si une donnée est écrite dans la mémoire, elle sera stockée en donnée inversée pour être ré-inversée en sortie, lorsqu'elle est lue.

Ces dispositifs peuvent s'appliquer aux cellules de mémoire dynamique à un ou plusieurs transistors.

Ces dispositifs s'appliquent à des mémoires dynamiques en boitier ou à l'intérieur de circuits plus complexes.

Le dispositif de choix de 1 ou de 0 ne doit pas nécessairement être intégré avec la mémoire dynamique.

La décharge du niveau stocké lors du couplage du conducteur B peut s'effectuer soit par le transistor rendu passant, soit par polarisation directe de la jonction du transistor liée au conducteur A et fuite dans le substrat.

L'invention permet ainsi par exemple:

de remplir un plan mémoire d'un niveau logique pour chaque pixel (cas d'un plan image);

d'initialiser une mémoire;

de tester en fin de process de fabrication une mémoire complète, pour baisser le coût du produit final car ce test étant rapide peut être appliqué à des lots importants;

de recopier un registre à un niveau logique sur toutes les lignes d'une mémoire d'image (copy mode).

Pour charger l'attribution de 1 ou 0, il faut une sélection de mode "champ de 1" ou "champ de 0". Pour cela on a décrit un mode de réalisation de commande des inverseurs de sortie intégrés à la mémoire. Ces circuits peuvent être implantés à l'extérieur du circuit mémoire.

Dans un exemple de réalisation, la mémoire dynamique est couplée avec un microprocesseur. Les inverseurs sont simulés par un logiciel convenable.

Dans un autre mode de réalisation, la tension de substrat est utilisée à la place de celle de la ligne de charge BL pour décharger la capacité de cellule.

**Revendications**

1. Mémoire dynamique comportant, pour chaque cellule, une capacité de stockage (CS) et un transistor (T) placé, en série avec la capacité de stockage (CS), entre une ligne de bit (BL) et une première borne (A) de la capacité de stockage (CS) et commandé sur sa grille par une ligne de mot (WL), la seconde borne (B) de la capacité de stockage (CS) de chaque cellule étant connectée à un générateur de potentiel (GP) qui pendant que les lignes de mot sont maintenues à un potentiel de repos, déplace puis replace le potentiel sur la seconde borne (B), de manière à déplacer puis à replacer, par couplage capacitif, le potentiel sur la première borne (A), ce qui a pour effet, selon l'état de l'information stockée dans une cellule concernée, la décharge de la capacité, soit par le transistor (T) rendu passant, soit par polarisation directe de la jonction du transistor et fuite dans le substrat, de façon à mettre toutes les cellules à un même niveau physique.

2. Mémoire dynamique selon la revendication 1, caractérisée en ce que au moins un groupe de cellules est connecté par une électrode (P) de plaque commune au générateur de potentiel (GP).

3. Mémoire dynamique selon la revendication 1, caractérisée en ce qu'elle comporte des moyens pour sélectionner un mode de fonctionnement dans un champ d'une valeur logique (0 ou 1) qui comportent un signal de commande (C) qui indique le niveau logique à écrire pour mettre toutes les cellules de la mémoire au même niveau logique.

4. Mémoire dynamique selon la revendication 3, caractérisée en ce que le signal de commande (C) est élaboré par un circuit interne à la mémoire à partir d'au moins un signal de contrôle comme le signal d'initialisation de l'ensemble de la mémoire.

5. Mémoire dynamique selon la revendication 4, caractérisée en ce que les moyens pour sélectionner un mode de fonctionnement comportent des amplificateurs inverseurs connectés ou non selon le signal de commande (C) entre la ligne de charge LI et les bornes d'attaque (DI, DO).

6. Mémoire dynamique selon la revendication 5, caractérisée en ce que, la mémoire dynamique étant intégrée avec un microprocesseur, les amplificateurs sont simulés par une routine de logiciel.

7. Mémoire dynamique selon la revendication 2, caractérisée en ce que la décharge des capacités de cellules est réalisée par variation de la tension de substrat.

**Patentansprüche**

1. Dynamischer Speicher, der für jede Zelle eine Speicherkapazität (CS) sowie einen Transistor (T) umfaßt, welcher zwischen einer Bitleitung (BL) und einer ersten Klemme (A) der Speicherkapazität (CS) mit der Speicherkapazität (CS) in Reihe geschaltet ist und an seiner Steuerelektrode über eine Wortleitung (WL) gesteuert wird, wobei die zweite Klemme (B) der Speicherkapazität (CS) jeder Zelle an einen Potentialgenerator (GP) angeschlossen ist, der, während die Wortleitungen auf einem Ruhepotential gehalten werden, das Potential von der zweiten Klemme (B) fortnimmt und es dann an die zweite Klemme (B) wieder anlegt, so daß durch kapazitive Koppelung das Potential von der ersten Klemme (A) fortgenommen und dann an die erste Klemme (A) wieder angelegt wird, was je nach dem Zustand der in einer betroffenen Zelle gespeicherten Information die Entladung der Kapazität entweder durch den leitend gemachten Transistor (T) oder durch Vorspannung des Übergangs des Transistors in Durchlaßrichtung und Lecksstrom in das Substrat bewirkt, so daß alle Zellen auf ein selbes physikalisches Niveau gesetzt werden.

2. Dynamischer Speicher nach Anspruch 1, dadurch gekennzeichnet, daß wenigstens eine Gruppe von Zellen durch eine Elektrode (P) einer gemeinsamen Platte an den Potentialgenerator (GP) angeschlossen ist.

3. Dynamischer Speicher nach Anspruch 1, dadurch gekennzeichnet, daß er Mittel zum Auswählen eines Arbeitsmodus in einem Feld mit einem logischen Wert (0 oder 1) umfaßt, die ein Steuersignal (C) umfassen, das den einzuschreibenden logischen Pegel anzeigt, um alle Zellen des Speichers auf dasselbe logische Niveau zu setzen.

4. Dynamischer Speicher nach Anspruch 3, dadurch gekennzeichnet, daß das Steuersignal (C) durch eine interne Schaltung des Speichers ausgehend von wenigstens einem Kontrollsignal wie dem Initialisationssignal für den gesamten Speicher erzeugt wird.

5. Dynamischer Speicher nach Anspruch 4, dadurch gekennzeichnet, daß die Mittel zum Auswählen eines Arbeitsmodus invertierende Verstärker umfassen, die je nach dem Steuersignal (C) zwischen die Lastleitung LI und die Ansteuerklemmen (DI, DO) geschaltet oder nicht geschaltet werden.

6. Dynamischer Speicher nach Anspruch 5, dadurch gekennzeichnet, daß der dynamische Speicher mit einem Mikroprozessor integriert ist und die Verstärker durch eine Programmroutine simuliert werden.

7. Dynamischer Speicher nach Anspruch 2, dadurch gekennzeichnet, daß die Entladung der Kapazitäten der Zellen durch Veränderung der Spannung des Substrats erfolgt.

**Claims**

1. A dynamic memory comprising, for each cell, a memory capacitor (CS) and a transistor (T) placed in series with the memory capacitor (CS) between a bit line (BL) and a first terminal (A) of the memory capacitor (CS) and controlled at the gate thereof by a word line (WL), the second terminal (B) of the memory capacitor (CS) of each cell being connected with a potential generator (GP) which, during the time in which the word lines are maintained at a resting potential, displaces and then replaces the potential on the second terminal (B) in such a manner as to displace and then replace, by capacitive coupling, the potential on the first terminal (A), the effect of this being, in accordance with the state of the information stored in a relevant cell, the discharge of the capacitor, either by way of the transistor (T) turned on, or by way of direct polarization of the junction of the transistor and escape into the substrate in such a manner as to put all the cells at the same physical level.

2. The dynamic memory as claimed in Claim 1, characterized in that at least one group of cells is connected by a common plate electrode (P) with the potential generator (GP).

3. The dynamic memory as claimed in Claim 1, characterized in that it comprises means in order to select a mode of functioning in a field with a logical value (0 or 1) which comprises a command signal (C) which indicates the logical level to be written in order to put all the cells of the memory at the same logical level.

4. The dynamic memory as claimed in Claim 3, characterized in that the command signal (C) is elaborated by a circuit internal to the memory starting from at least one control signal as the initializing signal of the memory array.

5. The dynamic memory as claimed in Claim 4, characterized in that the means for selecting a mode of functioning comprise inverting amplifiers which are connected or are not connected dependent on the command signal (C) between the load line L1 and the input terminals (D1 and DO).

6. The dynamic memory as claimed in Claim 5, characterized in that the dynamic memory is integrated with a microprocessor and the amplifiers are emulated by a software routine.

7. The dynamic memory as claimed in Claim 2, characterized in that the discharge of the capacitors of the cells is effected by variation of the substrate voltage.

# FIG_1

# FIG_2-a   FIG_2-b   FIG_2-c

# FIG_3